# EUROPEAN PATENT APPLICATION

(11) **EP 2 770 024 A1**
(43) Date of publication of application: **27.08.2014**
(21) Application number: 11874126.3
(22) Date of filing: 18.10.2011
(51) Int. Cl.: C08L 63/00, C08G 59/20, C08G 59/40, C08G 59/32, C08G 59/42, H05K 1/03

(54) **EPOXY RESIN COMPOSITION AND PREPREG AND COPPER CLAD LAMINATE MANUFACTURED BY USING THE SAME**

(71) Applicant: Guangdong Shengyi Sci. Tech Co., Ltd, Dongguan, Guangdong 523000 (CN)
(72) Inventor: ZENG, Xianping, Dongguan Guangdong 523000 (CN)
(74) Representative: Wallinger, Michael
(86) International application number: PCT/CN2011/080891
(87) International publication number: WO 2013/056411

(57) **Abstract**

Epoxy resin composition and prepreg and copper clad laminate manufactured by using the same are provided. The epoxy resin composition comprises the following essential components: (A) epoxy resin containing naphthol structure; (B) active ester curing agent; (C) curing accelerant. The epoxy composition in this invention can be used to prepare epoxy resin condensate with low water absorption and low dielectric loss value. The prepreg and copper clad laminate manufactured have good dielectric properties, moisture and heat resistance performance and high glass transition temperature.

## Description

### Technical Field

The present invention relates to a resin composition, particularly to an epoxy resin composition and prepreg and copper clad laminate manufactured from the same.

### Background Art

With the high speed and multifunction of the electronic information processing, and the continuously improvement of the application frequency, 3- 6GHz will become mainstream. In addition to maintaining a higher demand on the heat resistance of the laminate materials, the dielectric constant and dielectric loss value will demand lower and lower. Existing traditional FR-4 material is difficult to meet the needs of high-frequency and high-speed development of electronic products, while the substrate material is no longer a mechanical support role played in the traditional sense, rather, it will, together with electronic components, become an important way for PCB and terminal manufacturers designers to improve the product performance. High DK causes the signal transfer rate slow, and high Df causes the signal partly convert into heat loss in the substrate material, so reducing the DK / Df has become the hot pursuit of the substrate industry. Conventional FR-4 material mainly uses dicyandiamide as a curing agent. This curing agent has good process operability for a tertiary amine reaction, but due to high cracking at high temperatures for the weak carbon-nitrogen bond, which results the condensate has lower decomposition temperature and is unable to adapt to the heat requirements of lead-free processes. In this context, with wide range implementation of Lead-free process in 2006, the industry began to use novolac resin as a curing agent of epoxy resin. Novolac resin has high thermotolerant density of benzene ring structure, so epoxy curing system posses excellent heat-resistance quality, but at the same time the dielectric properties of the curing product arises the trend of deterioration.

Japanese Patent Laid-open 2002-012650, 2003-082063 proposed to synthesize a series of active ester curing agent containing a benzene ring, a naphthalene ring or a biphenyl structure as the curing agent of epoxy resins, such as Iaan IABN TriABN TAAN. The curing product significantly reduced dielectric constant and dielectric loss value compared with traditional Novolac aldehyde.

Japanese Patent Application Laid-open 2003-252958 proposed to use a biphenyl type epoxy resin and an active ester as a curing agent, which could obtain curing product to reduce the dielectric constant and dielectric loss value. But due to a di-functional activity of epoxy resin and low curing crosslinking density of active ester, the curing products have low heat resistance property and low glass flower temperature.

Japanese Patent Laid-open 2004-155990 obtained a poly-functional curing agent by an reaction between ester of aromatic carboxylic acid and an aromatic phenol, the curing product having higher heat resistance, better dielectric constant and dielectric loss value can be obtained by using the active ester curing agent to cure epoxy-containing naphthol structure.

Japanese Patent Laid-open 2009-235165 proposed a new poly-functional active esters curing agent. The curing products having a higher glass flower transition temperature, a low dielectric constant and dielectric loss was obtained by using this curing agent to cure the epoxy-containing aliphatic structure.

Japanese Patent Application Laid-open 2009-040919 proposed a thermosetting resin composition having dielectric constant stability and excellent conductive layer junction, which mainly comprises an epoxy resin, an active ester hardening agent, a hardening accelerator, an organic solvent.

They also researched on an amount of the epoxy resin and the active ester, but not studied on the structure and performance of the relationship between epoxy resin and an active ester.

In addition, Japanese Patent Laid-open 2009-242559, 2009-242560, 2010 - 077 344, 2010-077343 proposed respectively to obtain a curing product of low hygroscopicity, low dielectric constant and dielectric loss tangent by using alkylated phenol or alkylated naphthol novolac type epoxy resins, biphenyl novolac epoxy resin.

Although all patent mentioned above have submitted using an active ester as an epoxy resin can improve the moisture resistance of the curing product, reduce water absorption, and reduce dielectric constant and dielectric loss value, they have a drawback that it is difficult to obtain a good balance between heat resistance and dielectric properties, that is, the curing products having a high glass transition temperature and a low dielectric loss tangent at the same time, and having relatively stable dielectric properties as frequency variation, and have lower water absorption.

### Summary

The object of the present invention is to provide an epoxy resin composition, which can provide excellent dielectric properties, wet-heat resistance and a high glass transition temperature required by a copper-clad laminate.

Another object of the present invention is to provide a prepreg and copper clad laminate manufactured from the above-mentioned epoxy resin composition, which have excellent dielectric properties, heat-resistant properties, while also having a high glass transition temperature and more low water absorption.

To achieve the above-mentioned objects, the present invention provides an epoxy resin composition, which comprises the following essential components:
(A) epoxy resin containing naphthol structure;
(B) active ester curing agent;
(C) curing accelerant.

The component (A) epoxy resin containing naphthol structure comprises at least one epoxy resin having the following structural formula: 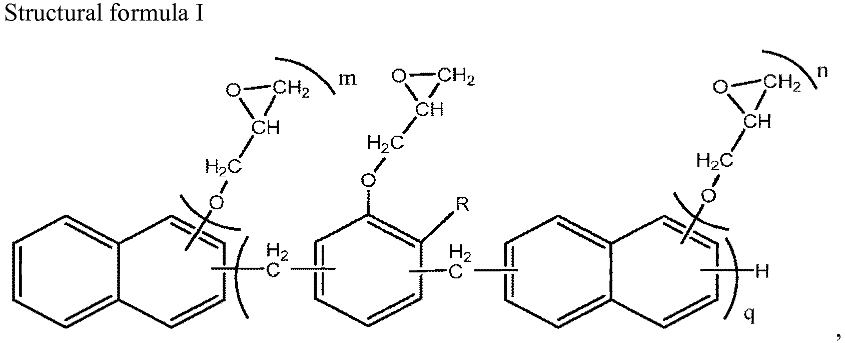 wherein
m and n are 1 or 2 respectively,
q is an integer between 1 and 10,
R is H, or alkyl group having 1 to 5 carbon atoms.

The components (B) active ester curing agent is obtained by the reaction of a phenol compound connected via aliphatic cyclic hydrocarbon structure, a difunctional carboxylic acid aromatic compound or acid halide and a monohydroxy compound.

the difunctional carboxylic acid aromatic compound or an acidic halide is used in an amount of 1 mol, the phenol compound connected via aliphatic cyclic hydrocarbon structure is used in an amount of 0.05-0.75mol, the monohydroxy compound is used in an amount of 0.25-0.95 mol.

The component (B) active ester includes an active ester of the following structural formula: 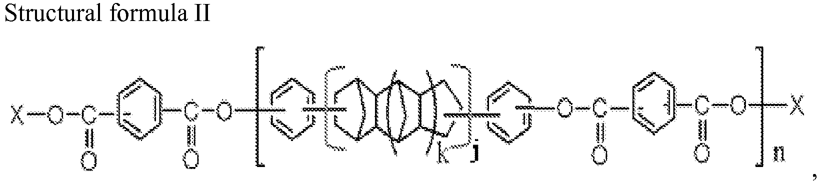 wherein
X is a benzene ring or a naphthalene ring,
j is 0 or 1,
k is 0 or 1,
n means the average repeating unit and is 0.25-1.25.

The curing accelerator is one compound selected from imidazole compounds and piperidine compounds, or mixture thereof.

The epoxy resin composition further comprises a flame retardant, wherein the flame retardant is mixed preferably in 5-100 parts by weight based on 100 part by weight of the sum of component (A), component (B) and component (C);
the flame retardant is a bromine-containing flame retardant or a non-halogen flame retardant, wherein the bromine-containing flame retardant is selected from decabromodiphenyl ether, decabromodiphenyl ethane, brominated styrene, ethylenebistetrabromophthalimide or brominated polycarbonates, and the non-halogen flame retardants is selected from tri(2,6-dimethyphenyl)phosphine, 10-(2,5-dihydroxyphenyl)-9,10- dihydrogen-9-oxa-10-phosphenanthrene-10-oxide, 2,6-bis(2,6-dimethylphenyl) phosphenyl, 10-phenyl-9,10-dihydrogen-9-oxa-10-phosphenanthrene-10-oxide, phenoxy phosphonic cyanide compounds, zinc borate, phosphate esters, polyphosphate esters, phosphorous-containing flame retardants, silicon-containing flame retardants, or nitrogen-containing flame retardants.

The epoxy resin composition further comprises an organic or inorganic filler, wherein the filler is mixed preferably in 5-500 parts by weight based on 100 parts by weight of the sum of component (A), component (B) and component (C), wherein the inorganic filler is one or more selected from the group consisting of crystalline silica, fused silica, spherical silica, hollow silica, glass powder, aluminum nitride, boron nitride, silicon carbide, aluminum hydroxide, titanium oxide, strontium titanate, barium titanate, alumina, barium sulfate, talc powder, calcium silicate, calcium carbonate and mica, and wherein the organic filler is one or more selected from the group consisting of polytetrafluoroethylene powder, polyphenylene sulfide and polyether sulfone powder.

Meanwhile, the present invention provides a prepreg manufactured from the above epoxy resin composition, which comprises the enhancement material and the epoxy resin composition adhering thereon by impregnating and then drying.

The present invention further provides a copper clad laminates manufactured from the above epoxy resin composition, which comprises several stacked prepregs and the copper foil cladded on one or both sides of the stacked prepregs, wherein the prepreg is manufactured from the epoxy resin composition.

The advantages of the present invention are:
① the epoxy resin composition of the present invention uses an epoxy resin containing at least one naphthol structure in molecules structure, which have high degree of functionality and a high glass transition temperature; meanwhile, as naphthol group structure is induced into the molecule structure, the curing product has low water absorption and low expansion coefficient;
② the epoxy resin composition of the present invention uses the active ester as a curing agent, which fully achieve the merit that the reaction between active ester and epoxy resin does not generate polar groups, thereby the dielectric properties and wet-heat resistance is excellent; in addition, the epoxy resin containing specific naphthol structure further reduces the water absorption and the dielectric loss value of the resin curing product;
③ the prepreg and copper clad laminate of the present invention manufactured from the above-mentioned epoxy resin have excellent dielectric properties and wet-heat resistance, and also a high glass transition temperature.

### Detailed Description

The epoxy resin composition of the present invention contains the following essential components:
(A) epoxy resin containing naphthol structure;
(B) active ester curing agent;
(C) curing accelerant.

Based on the solid components by weight, the equivalent ratio of the dosage between the component (A) epoxy resin containing naphthol structure and the component (B) active ester curing agent is 0.9 to 1.2, which is calculated in accordance with the molar ratio.

The component (A) epoxy resin containing naphthol structure comprises at least one epoxy resin having the following structural formula: 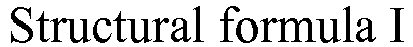 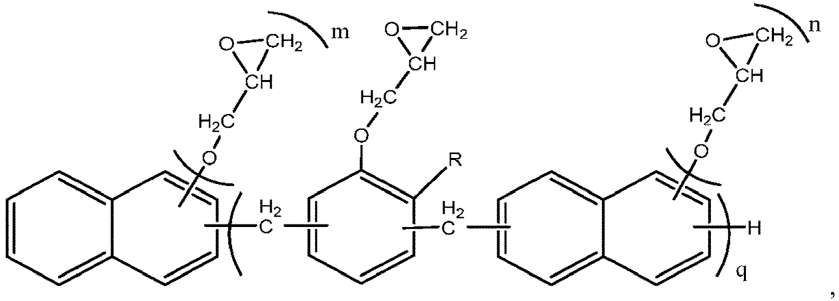 wherein
m and n are 1 or 2 respectively,
q is an integer between 1 and 10,
R is H, or alkyl group having 1 to 5 carbon atoms.

The above epoxy resin containing naphthol structure can be presented more specifically as the following structural formula: 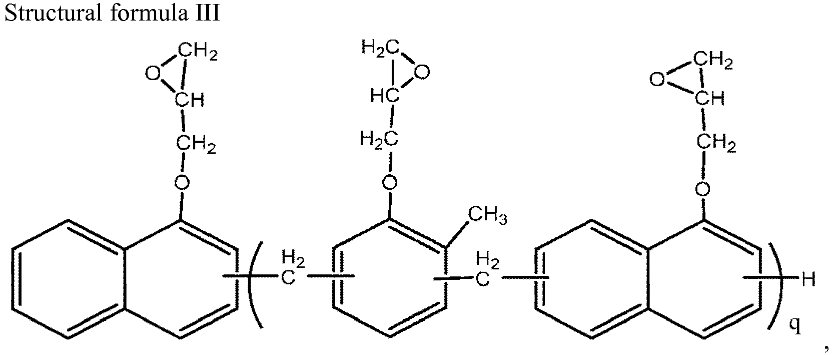 wherein q is an integer of between 1 and 10; 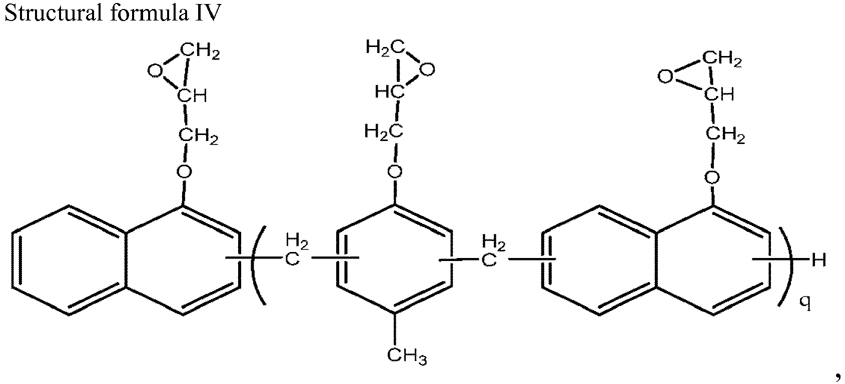 wherein q is an integer of between 1 and 10; 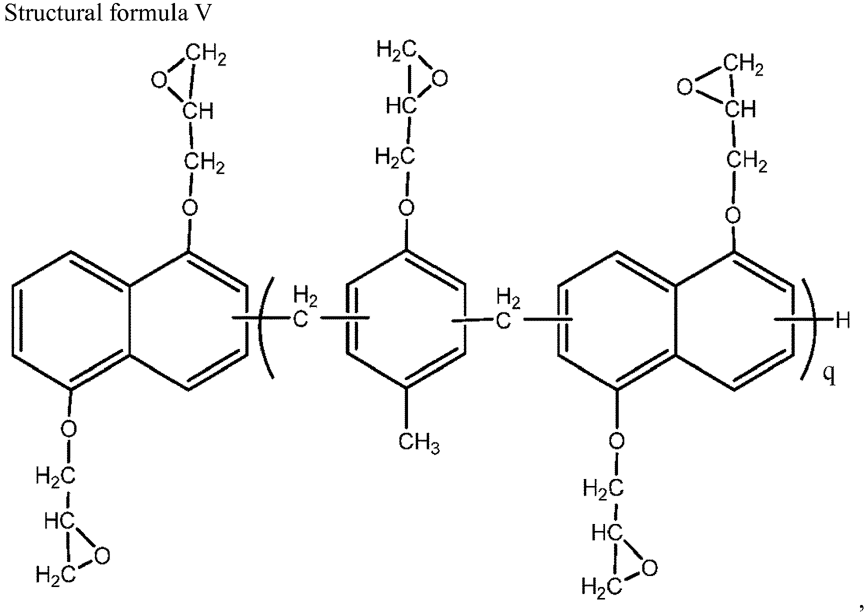 wherein q is an integer of between 1 and 10;

The component (B) active ester curing agent is obtained by the reaction of a phenol compound connected via aliphatic cyclic hydrocarbon structure, a di-functional carboxylic acid aromatic compound or acid halide and a monohydroxy compound. The di-functional carboxylic acid aromatic compound or an acidic halide is used in an amount of 1 mole, the phenol compound connected via aliphatic cyclic hydrocarbon structure is used in an amount of 0.05-0.75mol, the monohydroxy compound is used in an amount of 0.25-0.95 mol.

The component (B) active ester includes an active ester having the following structural formula: 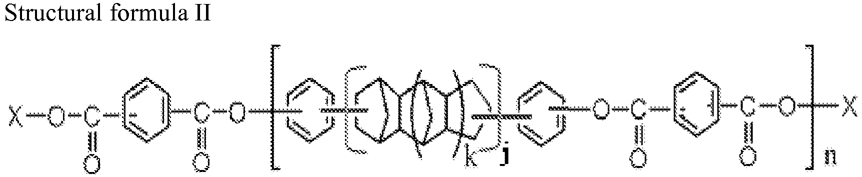 wherein
X is a benzene ring or a naphthalene ring,
j is 0 or 1,
k is 0 or 1,
n means the average repeating unit and is 0.25-1.25.

The curing accelerator is one selected from imidazole compounds and piperidine compounds, or mixture thereof. The curing accelerator is used in 0.05∼1.0 parts by weight based on 100 parts by weight of the sum of component (A) epoxy resin containing naphthol structure and component (B) active ester curing agent.

If necessary, the present invention can also comprise a flame retardant to provide flame retardant property for the resin curing product in accordance with UL 94 V-0 requirements. There is no specific limitation on the flame retardant added as needed. The flame retardant can be a bromine-containing or non-halogen flame retardant, halogen flame retardant, monument-containing flame retardant, silicon-containing flame retardant, nitrogen-containing flame retardant, it being better not to affect the dielectric properties. The bromine-containing flame retardant can be selected from decabromodiphenyl ether, decabromodiphenyl ethane, brominated styrene, ethylenebistetrabromophthalimide or brominated polycarbonate. The non-halogen flame retardant is selected from tri(2,6-dimethyphenyl)phosphine, 10-(2,5-dihydroxyphenyl)-9,10-dihydrogen-9-oxa-10-phosphenanthrene-10-oxide, 2,6-bis(2,6-dimethylphenyl) phosphenyl, 10-phenyl-9,10-dihydrogen-9-oxa-10-phosphenanthrene-10-oxide, phenoxy phosphonic cyanide compounds, zinc borate, phosphate esters, polyphosphate esters, phosphorous-containing flame retardants, silicon-containing flame retardants, or nitrogen-containing flame retardants. Optional commercial material includes brominated flame retardants BT-93, BT-93W, HP-8010, HP-3010 from Albemarle; non-halogen flame retardants SP-100, PX-200, PX-202, FR-700, OP-930, OP-935, without limitation. The amount of the flame retardant is determined according to the UL 94 V-0 level requirements, and not specially limited. Preferably, the flame retardant is used in 5 to 100 parts by weight based on 100 parts by weight of the sum of component (A), component (B) and component (C); more preferably, 10 to 50 parts by weight.

If necessary, the present invention may further comprise organic or inorganic filler. There is no specific limitation on the filler added as needed. The inorganic filler can be one or more selected from crystalline silica, fused silica, spherical silica, hollow silica, glass powder, aluminum nitride and boron nitride, silicon carbide, aluminum hydroxide, titanium oxide, strontium titanate, barium titanate, alumina, barium sulfate, talc powder, calcium silicate, calcium carbonate, mica, etc. The organic filler can be one or more selected from polytetrafluoroethylene powder, polyphenylene sulfide, polyether sulfone powder, one or more of ethylene powder, polyphenylene sulfide, polyether sulfone powder, etc. In addition, there is no specific limitation on shape and particle size of the inorganic filler. The particle size of the inorganic filler is usually 0.01-50 um, preferably 0.01 to 20 um, particularly preferably 0.1 to 10 um. It is easier to disperse for this range of the particle size. Furthermore, there is no specific limitation on the dosage of the filler. Preferably, the filler is used in 5-1000 parts by weight based on 100 parts by weight of the sum of component (A), component (B) and component (C), preferably 5-300 parts by weight, more preferably 5-200 parts by weight, particularly preferably 5-150 parts by weight.

The prepreg manufactured from the above-mentioned epoxy resin composition comprises the enhancement material and the epoxy resin composition adhering thereon by impregnating and then drying. The enhancement material uses the enhancement material according to prior art, such as glass fabric and the like. The copper-clad laminate manufactured from the above epoxy resin composition comprises several stacked prepregs, and copper foil(s) cladded on one or both sides of the stacked prepregs. The prepreg is manufactured from the epoxy resin composition.

The epoxy resin composition of the present invention is made to a glue of certain concentration. The enhancement material is impregnated into the glue and dried at certain temperature to remove solvent, thereby making the resin composition semi-cure to obtain the prepreg. After that, one above-mentioned prepreg are placed or more above-mentioned prepregs are stacked together in certain order, then a copper foil is cladded on both sides of the prepreg or the stacked prepregs, obtaining the copper-clad laminate in a hot press machine. The curing temperature is 150-250°C and the curing pressure is 25-60 Kg/cm².

For the copper clad laminate made as mentioned above, dielectric constant, dielectric loss factor, glass transition temperature and wet-heat resistance are all measured, and further described referring to the following embodiments.

### Embodiment 1:

To a container were added naphthol novolac epoxy resin NC-7300L in 100 parts by weight and HPC-8000-65T in an equivalent weight. The mixture was stirred, then to it were added appropriate amount of DMAP and the solvent toluene, obtaining a glue after stirring to uniformity. Glass fabric (model number: 2116, with a thickness of 0.08 mm) is impregnated into the glue solution, and are controlled to an appropriate thickness. Then the glass fiber cloth is dried to remove the solvent, thereby obtaining a prepreg. Several such prepregs are stacked, and two copper foils are cladded on both sides of the stacked prepregs, obtaining a copper clad laminate in a hot press machine. Physical property data of the copper-clad laminate is shown in Table 1.

### Embodiments 2 to 3:

The manufacturing process is the same as that in embodiment 1. The formulas and physical property data is shown in Table 1.

### Comparison Example 1 to 3:

The manufacturing process is the same as that in tembodiment 1. The formulas and physical property data is shown in Table 1.

**Table 1 Formulas and Physical Property Data of Embodiments and Comparative Examples**

| Component | Embodiment 1 | Embodiment 2 | Embodiment 3 | Comparative Example 1 | Comparative Example 2 | Comparative Example 3 |
|---|---|---|---|---|---|---|
| NC-7300L | 100 | --- | --- | --- | --- | --- |
| NC-7000L | --- | 100 | --- | --- | --- | --- |
| NC-7700L | --- | --- | 100 | --- | --- | --- |
| HP-7200H | --- | --- | --- | 100 | --- | 100 |
| N-6900 | --- | --- | --- | --- | 100 | --- |
| HPC-8000-65T | 1eq | 1eq | 1eq | 1eq | 1eq | --- |
| TD-2090 | --- | - | --- | --- | - | 1eq |
| DMAP | 0.15 | 0.15 | 0.15 | 0.15 | 0.15 | --- |
| 2E4MZ | --- | --- | --- | --- | --- | 0.075 |
| Tg(DMA)/°C | 180 | 190 | 210 | 165 | 160 | 200 |
| Dk(5g) | 3.7 | 3.8 | 3.7 | 3.9 | 3.9 | 4.4 |
| Df(5g) | 0.007 | 0.0075 | 0.007 | 0.011 | 0.014 | 0.019 |
| Water Absorption% | 0.12 | 0.13 | 0.13 | 0.13 | 0.18 | 0.30 |
| Wet-heat Resistance | 3/3 | 3/3 | 3/3 | 3/3 | 3/3 | 2/3 |

| | | | | | | |
|---|---|---|---|---|---|---|
| The materials listed in the table are particularly as follows: NC-7300L: naphthol novolac epoxy resin with epoxy equivalent of 214g/eq; NC-7000L: naphthol novolac epoxy resin with epoxy equivalent of 232g/eq; NC-7700L: naphthol novolac epoxy resin with epoxy equivalent of 233g/eq; HP-7200-H: di-cyclopentadiene novolac epoxy resin with epoxy equivalent: of 280g/eq; N-690: o-cresol novolac epoxy resin with epoxy equivalent of 215g/eq; HPC-8000-65T: active ester curing agent with active ester equivalent of 223g/eq; TD-2090: Phenol novolac curing agent with hydroxyl group equivalent of 105g/eq; DMAP: 4-dimethylaminopyridine; 2E4MZ: 2-ethyl-4-methylimidazole. | | | | | | |

The test method of the above properties is as follows:
(1) glass transition temperature (Tg): measured via the DMA assay prescribed in accordance with IPC-TM-650 2.4.24.
(2) dielectric constant and dielectric loss factor: measured according to SPDR method.
(3) wet-heat resistance evaluation: the substrate lamina was evaluated after the copper foil on the surface of copper-clad laminate was etched; the substrate lamina is placed in a pressure cooker, and treated at 120 ° C and under 105KPa for 2h; then the substrate lamina is impregnated in a tin furnace at 288 ° C; once the substrate lamina is delaminated, record the corresponding time; if no bubble or delamination occurred after the substrate lamina was in a tin furnace for 5min, the evaluation can be finished.

### Physical Properties Analysis

As can be known from the physical property data shown in table 1: for comparative examples 1-2 using the existing novolac epoxy resin and being cured by active ester, the glass transition temperature is ordinary, the dielectric properties and water-absorption rate are improved compared with common used epoxy resin, and the wet-heat resistance is good; for comparative example 3 having same structure and being cured by a novolac resin, the glass transition temperature is good, however, both dielectric properties and wet-heat resistance are poor; for embodiments 1-3 co-cured using naphthol novolac epoxy resin and active ester, the obtained laminate material have low water absorption, excellent dielectric properties and wet-heat resistance and high glass transition temperature.

In summary, compared with the common used copper-clad laminate, the copper-clad laminate of the present invention has more excellent dielectric properties, higher glass transition temperature, and better wet-heat resistance, and thus is suitable for high frequency fields.

The above embodiments are merely preferred examples of the present invention. Those skilled in the art can make numerous variations and changes according to the technical solution and spirit of the present invention, all of which fall into the protected scope prescribed by the claims of the present invention.

## Claims

1. An epoxy resin composition, which comprises the following essential components:
(A) epoxy resin containing naphthol structure;
(B) active ester curing agent;
(C) curing accelerant.

2. The epoxy resin composition of claim 1, wherein the Component (A) epoxy resin containing naphthol structure comprises at least one epoxy resin having the following structural formula: 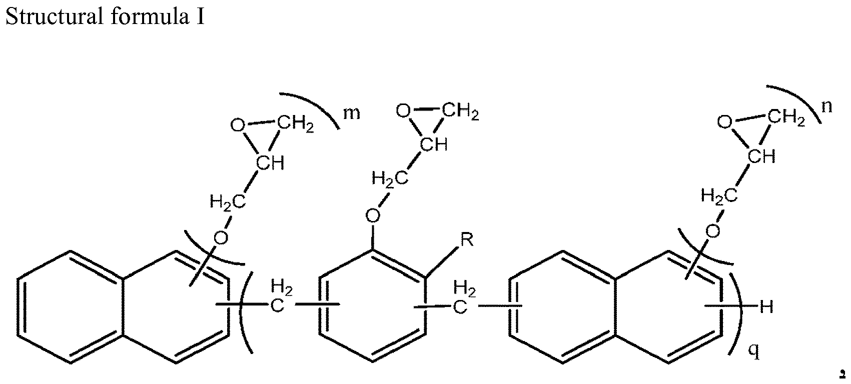 wherein
m and n are 1 or 2 respectively,
q is an integer between 1 and 10,
R is H, or alkyl group having 1 to 5 carbon atoms.

3. The epoxy resin composition of claim 1, wherein the component (B) active ester curing agent is obtained by the reaction of a phenol compound connected via aliphatic cyclic hydrocarbon structure, a difunctional carboxylic acid aromatic compound or acid halide and a monohydroxy compound.

4. The epoxy resin composition of claim 3, wherein the difunctional carboxylic acid aromatic compound or an acidic halide is used in an amount of 1 mol, the phenol compound connected via aliphatic cyclic hydrocarbon structure is used in an amount of 0.05-0.75mol, the monohydroxy compound is used in an amount of 0.25-0.95 mol.

5. The epoxy resin composition of claim 1, wherein the Component (B) active ester includes the active ester of the following structural formula: 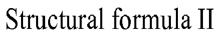 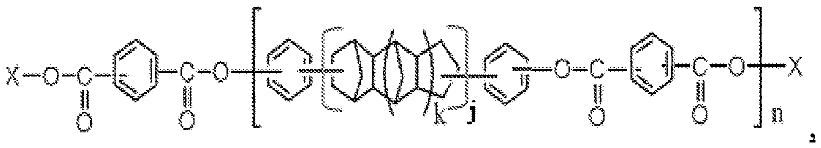 wherein
X is a benzene ring or a naphthalene ring,
j is 0 or 1,
k is 0 or 1,
n means the average repeating unit and is 0.25-1.25.

6. The epoxy resin composition of claim 1, wherein the curing accelerator is one selected from imidazole compounds and piperidine compounds, or mixture thereof.

7. The epoxy resin composition of claim 1, further comprising a flame retardant, wherein the flame retardant is mixed preferably in 5-100 parts by weight based on 100 part by weight of the sum of component (A), component (B) and component (C); the flame retardant is a bromine-containing flame retardant or a non-halogen flame retardant, wherein the bromine-containing flame retardant is selected from decabromodiphenyl ether, decabromodiphenyl ethane, brominated styrene, ethylenebistetrabromophthalimide or brominated polycarbonates, and the non-halogen flame retardants is selected from tri(2,6-dimethyphenyl)phosphine, 10-(2,5-dihydroxyphenyl)-9,10- dihydrogen-9-oxa-10-phosphenanthrene-10-oxide, 2,6-bis(2,6-dimethylphenyl) phosphenyl, 10-phenyl-9,10-dihydrogen-9-oxa-10-phosphenanthrene-10-oxide, phenoxy phosphonic cyanide compounds, zinc borate, phosphate esters, polyphosphate esters, phosphorous-containing flame retardants, silicon-containing flame retardants, or nitrogen-containing flame retardants.

8. The epoxy resin composition of claim 1, further comprising an organic or inorganic filler, the filler is mixed preferably in 5-500 parts by weight based on 100 parts by weight of the sum of component (A), component (B) and component (C), wherein the inorganic filler is one or more selected from the group consisting of crystalline silica, fused silica, spherical silica, hollow silica, glass powder, aluminum nitride, boron nitride, silicon carbide, aluminum hydroxide, titanium oxide, strontium titanate, barium titanate, alumina, barium sulfate, talc powder, calcium silicate, calcium carbonate and mica, and the organic filler is one or more selected from the group consisting of polytetrafluoroethylene powder, polyphenylene sulfide and polyether sulfone powder.

9. The prepreg manufactured from the epoxy resin composition of claim 1, comprising the enhancement material and the epoxy resin composition adhering thereon by impregnating and then drying.

10. The copper clad laminates manufactured from the epoxy resin composition of claim 1, comprising several stacked prepregs and the copper foil cladded on one or both sides of the stacked prepregs, wherein the prepreg is manufactured from the epoxy resin composition.
